# EUROPÄISCHE PATENTANMELDUNG

(11) **EP 1 681 767 A1**
(43) Veröffentlichungstag der Anmeldung: **19.07.2006**
(21) Anmeldenummer: 05000712.9
(22) Anmeldetag: 14.01.2005
(51) Int. Cl.: H03K 17/96

(54) **Schaltelement**

(71) Anmelder: Delphi Technologies, Inc., Troy, MI 48007 (US)
(72) Erfinder: Dubbert, Stefan, 58332 Schwelm (DE); Kaluba, Thomas, 42659 Solingen (DE); Lahme, Nicole, 40699 Erkrath (DE)
(74) Vertreter: Manitz, Finsterwald & Partner GbR

(57) **Zusammenfassung**

Die Erfindung betrifft ein Schaltelement mit Beleuchtungsfunktion, mit einer Leiterplatte, wenigstens einer piezoelektrischen Lackstruktur und wenigstens einem elektrischen Leuchtelement auf der Leiterplatte.

## Beschreibung

Die Erfindung betrifft ein beleuchtetes Schaltelement mit einem elektrischen Leuchtelement und einer Schaltfunktion. Weiterhin betrifft die Erfindung Verwendungen eines solchen Schaltelementes.

Um auch bei schlechten Lichtverhältnissen eine sichere Bedienung von Schaltern und Betätigungselementen zu gewährleisten, werden beleuchtete Schalter und Tastenelemente eingesetzt. Die Beleuchtung kann dabei direkt im Schalter oder Tastenelement integriert sein. Bei bekannten Lösungen ist ein elektrischer Kontakt vorgesehen, der bei Betätigen des Schaltelementes mit einem weiteren elektrischen Kontakt in Verbindung gebracht wird, so dass ein elektrisches Schaltsignal erzeugt werden kann. Der dazu notwendige Schalter bzw. die dazu notwendige Taste umfasst eine Leuchte, zum Beispiel zur Beleuchtung des Schalters. Damit ist es möglich, dass der Schalter zum einen beleuchtet wird und zum anderen eine Schaltfunktion ausübt.

Bei anderen Anwendungen, zum Beispiel üblichen Kennzeichenbeleuchtungen für Kraftfahrzeuge, ist die Beleuchtungsfunktion nicht notwendigerweise zur Beleuchtung der Schalter bzw. Tasten selbst vorgesehen. Im genannten Beispiel ist eine Beleuchtung des Kennzeichens notwendig und nur in der Nachbarschaft befindet sich ein Schaltelement zum Öffnen des Kofferraums bzw. der Heckklappe.

Aufgabe der vorliegenden Erfindung ist es, ein Schaltelement mit Beleuchtungsfunktion anzugeben, das ohne großen mechanischen Aufwand auskommt und einfach und kostengünstig ist. Diese Aufgabe wird mit einem Schaltelement mit Beleuchtungsfunktion mit den Merkmalen des Anspruchs 1 gelöst. Unteransprüche sind auf bevorzugte Ausführungsformen gerichtet. Eine besonders vorteilhafte Verwendung ist Gegenstand des Anspruchs 8. Ansprüche 9 und 10 sind auf eine Kennzeichenbeleuchtung bzw. einen Tür- oder Klappengriff mit einem Schaltelement mit den Merkmalen des Anspruchs 1 gerichtet.

Im vorliegenden Text wird der Begriff "Schaltelement" umfassend für Schalter, Tasten und andere Betätigungselemente verwendet.

Ein erfindungsgemäßes Schaltelement mit Beleuchtungsfunktion weist eine Leiterplatte mit einer piezoelektrischen Lackstruktur auf. Auf der Leiterplatte ist wenigstens ein elektrisches Leuchtelement mit entsprechenden Kontaktstrukturen vorgesehen. Schließlich weist das beleuchtete Schaltelement eine Auswerteeinheit zur Auswertung von Spannungsimpulsen der piezoelektrischen Lackstruktur zur Erzeugung eines elektrischen Schaltsignals auf.

Das erfindungsgemäße Schaltelement kombiniert auf einer Leiterplatte sowohl eine Beleuchtungsfunktion als auch eine Schaltfunktion. Durch Verwendung von piezoelektrischem Lack sind aufwändige mechanische Konstruktionen zur Realisierung der Schaltfunktion nicht notwendig. Durch die integrierte Ausführung, bei der auch das Leuchtelement auf derselben Leiterplatte vorgesehen ist, ist der Aufbau einfach und platzsparend. Die Aufbringung der piezoelektrischen Lackstruktur ist zum Beispiel mit lithographischen Verfahren bzw. durch Aufdrucken ausgehend von der Tastenform einfach durchführbar.

Eine besonders vorteilhafte Weiterbildung sieht eine flexible Leiterplatte als Träger vor. Als Material eignet sich zum Beispiel Polyesterfolie. Die Flexibilität des Trägermaterials ermöglicht einen sicheren Schaltvorgang unter Ausnutzung des piezoelektrischen Lacks. Außerdem lässt sich eine flexible Trägerstruktur an die Gegebenheiten des Gegenstandes anpassen, auf den sie aufgebracht werden soll. So kann das beleuchtete Schaltelement zum Beispiel auch auf einer gekrümmten Fläche vorgesehen werden.

Die Erfindung ist nicht darauf beschränkt, dass ein Schaltelement nur eine Schaltfunktion ausüben kann. Durch entsprechende Auswahl und Kontaktierung von piezoelektrischen Lackmustern können insbesondere bei Verwendung einer flexiblen Leiterplatte auch mehrere Schaltfunktionen auf einer Leiterplatte integriert werden. Es ergibt sich dann ein Bauelement, bei dem Druck auf unterschiedliche Stellen unterschiedliche Schaltfunktionen bewirken kann.

Bei der Auswerteeinheit zur Auswertung des Spannungssignals der piezoelektrischen Lackstruktur und zur Erzeugung eines elektrischen Schaltsignals kann es sich um ein gesondertes Elektronikmodul handeln. Kostengünstig und platzsparend ist eine Lösung, bei der sich die Auswerteeinheit ebenfalls auf der Leiterplatte befindet. Die Gesamteinheit ist dann kompakt und als integriertes Bauteil einsetzbar. Als Auswerteeinheit kann zum Beispiel ein ASIC-Bauteil verwendet werden.

Die piezoelektrische Lackstruktur und die Leuchtelemente können auf einer Seite der Leiterplatte vorgesehen sein. Gerade bei Anwendungen, bei denen die Tastfläche des Schaltelements selbst beleuchtet sein soll, bietet sich eine platzsparende Lösung an, bei der das elektrische Leuchtelement auf der einen Seite der Leiterplatte und die piezoelektrische Lackstruktur auf der anderen Seite der Leiterplatte vorgesehen sind. Bei einer Weiterbildung sind auch die Kontaktelemente für das wenigstens eine Leuchtelement und/oder die Auswerteeinheit auf der Seite der Leiterplatte vorgesehen, auf der auch das wenigstens eine Leuchtelement ist.

Als Leuchtelemente können zum Beispiel Leuchtdioden verwendet werden. Die Kontaktstrukturen umfassen Leiterbahnen und ggf. andere elektrische Bauelemente, wie Widerstände etc. Sowohl das wenigstens eine Leuchtelement als auch z.B. die Widerstände oder anderen Bauelemente können mit Hilfe eines Leitklebers auf einer Seite der Leiterplatte einfach aufgeklebt werden. Die Leiterbahnen können z.B. lithographisch aufgebracht bzw. aufgedruckt werden.

Die Leiterplatte mit dem wenigstens einen elektrischen Leuchtelement und der piezoelektrischen Lackstruktur kann zum Beispiel hinter einer Designblende vorgesehen werden, die vor äußeren Einflüssen schützt. Besonders vorteilhaft und robust ist eine Ausführungsform, die vollständig gedichtet ist. Dazu wird die Folie mit einem transparenten Schaum oder einem transparenten Lack überzogen. Eine solche Ausführungsform ist gegen Witterungseinflüsse geschützt und kann daher auch im Außenbereich verwendet werden.

Das erfindungsgemäße Schaltelement kann überall dort eingesetzt werden, wo eine Beleuchtungsfunktion und eine Schaltfunktion möglichst einfach und platzsparend vorgesehen sein sollen. Besonders vorteilhaft ist die Verwendung erfindungsgemäßer Schaltelemente im automobilen Bereich.

Hier ist eine Anwendung zum Beispiel besonders günstig, wenn Schaltelemente selbst beleuchtet werden sollen. Anwendungsfälle sind Innenraumschalter, wie z.B. Sitzverstellschalter, Schalter auf der Mittelkonsole oder Schalter im Dach.

Andere Anwendungen aus dem automobilen Bereich sehen zum Beispiel beleuchtete Tür- oder Klappengriffe vor. Die Beleuchtung dient dazu, dass der Türgriff auch bei schlechten Lichtverhältnissen leicht gefunden werden kann und die Schaltung dient dem Öffnen der Tür.

Die Beleuchtungsfunktion muss jedoch nicht notwendigerweise auch zur Beleuchtung des Schaltelementes selbst eingesetzt werden. Anwendungen sind denkbar, bei denen ein Schaltelement vorgesehen ist, das einen benachbarten Gegenstand beleuchten soll. Im automobilen Bereich ist dies zum Beispiel häufig bei Kennzeichenbeleuchtungen der Fall. Hier dient die Schaltfunktion zum Öffnen der Heckklappe bzw. des Kofferraumdeckels und die Beleuchtungsfunktion zur Beleuchtung des Kennzeichens.

Erfindungsgemäße Ausführungen werden anhand der beiliegenden Figuren im Detail erläutert. Dabei zeigt:
- Fig. 1: die Vorderseite eines erfindungsgemäßen Schaltelementes,
- Fig. 2: die Rückseite eines erfindungsgemäßen Schaltelementes,
- Fig. 3: eine Ausführungsform eines erfindungsgemäßen Schaltelementes mit mehreren Schaltfunktionen, und
- Fig. 4: eine Anwendung für eine Kennzeichenleuchte.

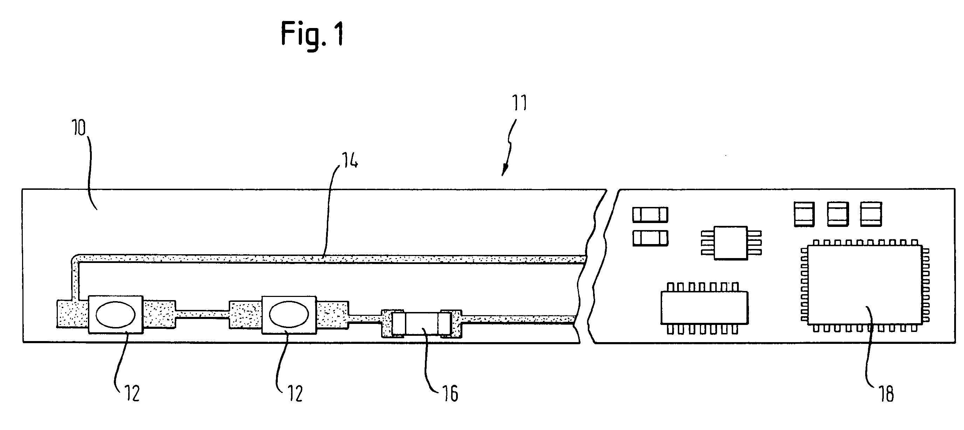

Fig. 1 zeigt die Vorderseite eines erfindungsgemäßen Schaltelementes 11 mit Beleuchtungsfunktion. Es umfasst bei dieser Ausführungsform eine Polyesterfolie 10 als Leiterplatte, auf deren Vorderseite eine Schaltung mit Leiterbahnen 14 aufgedruckt ist. Mit Leitkleber aufgebracht sind Leuchtdioden 12 und ein Widerstand 16. Auf derselben Seite des Elementes befindet sich ein ASIC-Bauteil 18. Die einzelnen Elemente sind in an sich bekannter Weise elektrisch kontaktiert.

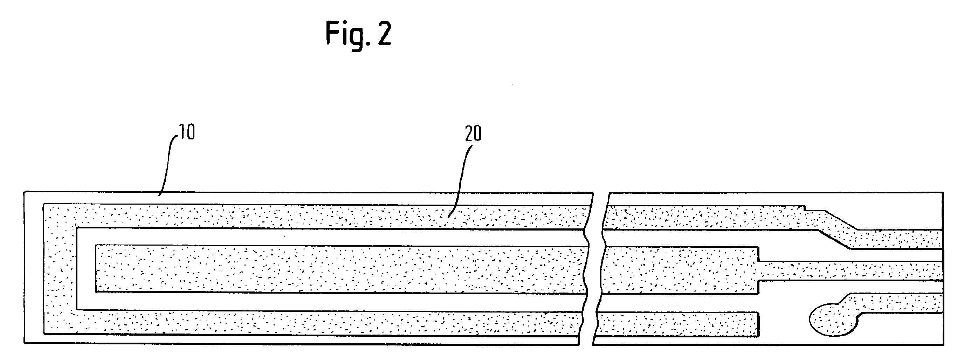

Fig. 2 zeigt die Rückseite der Polyesterfolie 10 mit der aufgedruckten piezoelektrischen Lackstruktur 20. Bei dem für die Schaltfunktion ausgenutzten piezoelektrischen Effekt wird äußere Krafteinwirkung bzw. Druckeinwirkung auf das piezoelektrische Material in ein Spannungssignal gewandelt. Zur vereinfachten Erläuterung wird z.B. ein Material mit sechsseitigen Kristall-Struktur-Zellen angenommen, in denen sämtliche Ladungen gegenseitig ausgeglichen sind, so dass die einzelne Zelle nach außen hin elektrisch neutral ist. Druck auf eine solche Zelle bewirkt eine Verschiebung der Schwerpunkte der negativen und positiven Ladungen gegeneinander. Die entstandene Ladungsdifferenz wird als Spannung oder Ladung ausgewertet. Ausreichend ist dabei zum Beispiel ein Hub von 1 bis 10 µm zur Erzeugung einer verwendbaren Schaltspannung oder Ladung.

Die Ausführungsform der Fig. 1 und 2 kann wie folgt eingesetzt werden. Über Leiterbahnen 14 und den Widerstand 16 werden die Leuchtdioden 12 mit Strom versorgt, so dass das Schaltelement leuchtet.

Druck auf die Vorderseite der Polyesterfolie 10 erzeugt wie beschrieben in dem piezoelektrischen Lack 20 eine auswertbare Ladungsdifferenz. Das entsprechende Signal wird durch in den Figuren nicht gesondert dargestellte Leitungen an das ASIC-Bauteil 18 weitergeleitet. Je nach Anwendung ist das ASIC-Bauteil 18 programmiert, um gewünschte Schaltfunktionen auszuüben.

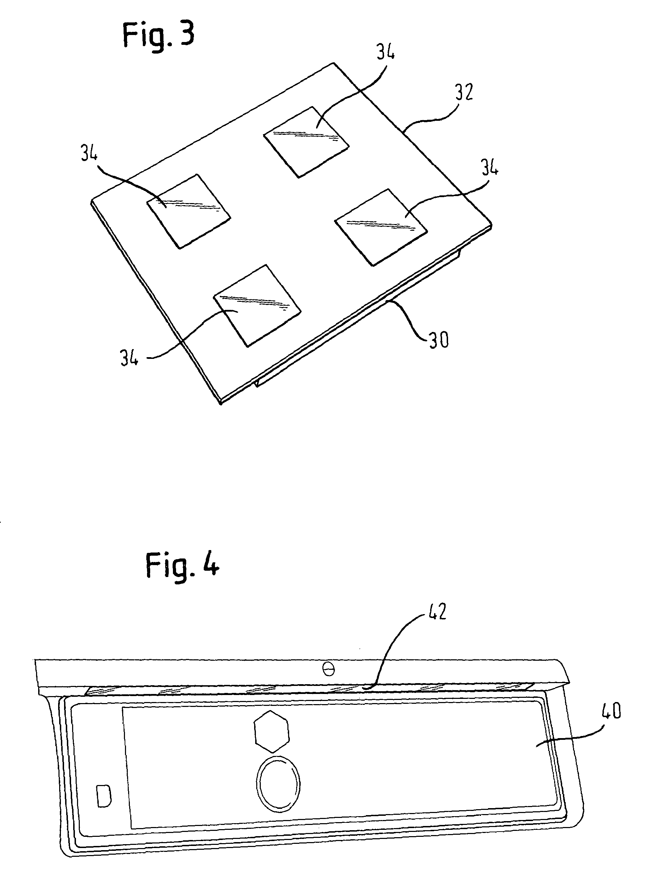

Fig. 3 zeigt eine Anwendung, bei der mehrere Tasten 34 aus transparentem Material in einer Designblende 32 vorgesehen sind. Unterhalb der Blende 32 befindet sich ein erfindungsgemäßes Schaltelement 30. Auf der der Blende 32 zugewandten Seite des Schaltelementes 30 sind in hier nicht sichtbarer Weise Leuchtdioden vorgesehen, die durch die Tasten 34 hindurchleuchten, um diese zu beleuchten. Auf der Unterseite des Schaltelementes 30 befinden sich an den Orten der Tasten 34 jeweils piezoelektrische Lackstrukturen, wie sie für ein einzelnes Schaltelement in Fig. 2 mit 20 bezeichnet sind. Je nachdem welche Taste 34 gedrückt wird, wird eine andere piezoelektrische Lackstruktur unter Druck gesetzt und erzeugt eine auswertbare Ladungsverschiebung. Bei dem gezeigten Ausführungsbeispiel sind also vier unterschiedliche Funktionen schaltbar.

Fig. 4 zeigt eine Kennzeichenbeleuchtung. Dabei ist ein erfindungsgemäßes Schaltelement an der Heckklappe bzw. dem Kofferraumdeckel eines Kraftfahrzeuges durch Clipsen oder Kleben befestigt. Die Leuchtstruktur 42, die z. B. aus einer Anzahl Leuchtdioden bestehen kann, wird hier zur Beleuchtung des Kennzeichens 40 verwendet. Die Schaltfunktion dient dem Öffnen der Heckklappe bzw. des Kofferraumes.

Um sicherzustellen, dass solche äußeren Anwendungen von Witterungseinflüssen unbeeinflusst bleiben, kann ein erfindungsgemäßes Schaltelement mit transparentem Lack oder transparentem Schaum überzogen sein.

### Bezugszeichenliste

- 10: Leiterplatte, Polyesterfolie
- 11: Schaltelement
- 12: Leuchtdioden
- 14: Leiterbahn
- 16: Widerstand
- 18: ASIC-Bauteil
- 20: piezoelektrische Lackstruktur
- 30: Schaltelement
- 32: Designblende
- 34: Tasten
- 40: Kennzeichen
- 42: Leuchtstruktur

## Patentansprüche

1. Schaltelement mit Beleuchtungsfunktion, mit
- einer Leiterplatte (10),
- wenigstens einer piezoelektrischen Lackstruktur (20) auf der Leiterplatte (10),
- wenigstens einem elektrischen Leuchtelement (12) auf der Leiterplatte (10),
- elektrischen Kontaktstrukturen (14, 16) auf der Leiterplatte (10) zur Kontaktierung des wenigstens einen elektrischen Leuchtelementes (12), und
- einer Auswerteeinheit zur Auswertung der Spannungssignale der piezoelektrischen Lackstruktur (20) und zur Erzeugung eines elektrischen Schaltsignals.

2. Schaltelement mit Beleuchtungsfunktion nach Anspruch 1,
bei der die Leiterplatte (10) flexibel ist und vorzugsweise eine Polyesterfolie umfasst.

3. Schaltelement mit Beleuchtungsfunktion nach Anspruch 2,
bei der mehrere piezoelektrische Lackstrukturen auf der flexiblen Leiterplatte (10) derart vorgesehen sind, dass mehrere Schaltfunktionen durch Drücken unterschiedlicher Stellen der Leiterplatte ausgelöst werden können.

4. Schaltelement mit Beleuchtungsfunktion nach einem der Ansprüche 1 bis 3,
bei der die Auswerteeinheit (18) auf der Leiterplatte (10) vorgesehen ist.

5. Schaltelement mit Beleuchtungsfunktion nach einem der Ansprüche 1 bis 4,
bei der die wenigstens eine piezoelektrische Lackstruktur (20) auf einer Seite der Leiterplatte (10) und das wenigstens eine elektrische Leuchtelement (12) auf der anderen Seite der Leiterplatte (10) vorgesehen sind.

6. Schaltelement mit Beleuchtungsfunktion nach Anspruch 5,
bei der die Kontaktelemente (14, 16) und/oder die Auswerteeinheit (18) auf der Seite der Leiterplatte (10) vorgesehen sind, auf der auch das wenigstens eine elektrische Leuchtelement (12) vorgesehen ist.

7. Schaltelement mit Beleuchtungsfunktion nach einem der Ansprüche 1 bis 6,
das mit transparentem Schaum oder transparentem Lack umgeben ist.

8. Verwendung eines Schaltelementes mit Beleuchtungsfunktion gemäß einem der Ansprüche 1 bis 7 im automobilen Bereich, insbesondere als Innenraumschalter, Kennzeichenbeleuchtung, Tür- oder Klappengriff.

9. Kennzeichenbeleuchtung mit einem Schaltelement mit Beleuchtungsfunktion nach einem der Ansprüche 1 bis 7,
bei der die Schaltfunktion des Schaltelementes zum Öffnen einer Heckklappe oder Kofferraumklappe dient und das Schaltelement derart angeordnet ist, dass das wenigstens eine elektrische Leuchtelement ein Kennzeichen (40) beleuchten kann.

10. Tür- oder Klappengriff mit einem Schaltelement mit Beleuchtungsfunktion nach einem der Ansprüche 1 bis 7,
bei dem die Schaltfunktion des Schaltelementes zum Öffnen einer Tür oder Klappe, insbesondere eines Kraftfahrzeuges, dient und das wenigstens eine elektrische Leuchtelement derart angeordnet ist, dass es einen Tür- oder Klappengriff beleuchten kann.
